# EUROPEAN PATENT APPLICATION

(11) **EP 2 442 077 A1**
(43) Date of publication of application: **18.04.2012**
(21) Application number: 10013529.2
(22) Date of filing: 12.10.2010
(51) Int. Cl.: G01D 11/24, H03K 17/95

(54) **Sensor assemblies**

(71) Applicant: Future Technology (Sensors) Ltd, Banbury Oxfordshire OX16 6EA (GB)
(72) Inventor: Elliot, Howard Windrush, Oxfordshire OX15 5BH (GB)
(74) Representative: Thacker, Darran Ainsley

(57) **Abstract**

The invention relates to a sensor assembly. The assembly includes a multi-layer sensor body (2) of appropriate construction (preferably substantially ceramic). A preformed ceramic disc (8) is bonded to a front part of the sensor body (2) to provide a hermetic seal that excludes gas from any interface between the constituent layers of the sensor body (2). The hermetic seal is maintained even if the sensor assembly is used at high operating temperatures.

## Description

### Technical Field

The present invention relates to sensor assemblies, and in particular to sensor assemblies that incorporate a ceramic body and can be used in high temperature operating environments.

The term "sensor assemblies" is intended to cover a wide variety of different sensor types and products as illustrated by the following (non-exhaustive) list: pressure sensors, strain gauge sensors, temperature sensors, capacitive sensors, displacement measurement sensors, blade tip timing sensors, blade tip clearance measurement sensors, inductive sensors, optical sensors and microwave sensors and infra-red sensors.

A further range of suitable products include electromagnetically transparent windows which are used to protect electromagnetically-based systems from the high temperature and pressure experienced in a gas turbine environment, for example. These windows can be made from materials such as sapphire, quartz and diamond, as well as more conventional ceramic materials. The term "transparent" is intended to refer to any materials which do not impede the path of the electromagnetic radiation to any significant degree. Such materials are usually chosen for use with specific measurement systems which incorporate optical, microwave or infra-red technology, for example.

### Background Art

Known sensor assemblies typically comprise composite ceramic/metal components that are brazed together using conventional brazing techniques. Such a known sensor assembly might include a metal housing with a metallised aluminium oxide bush brazed into the inner diameter of the housing. A sensor body is then brazed into the internal diameter of the bush.

The sensor body can be made of one or more layers of metal, electrically conductive ceramic, electrically non-conductive ceramic that is made conductive by having a layer of conductive material (e.g. a metal) deposited on its surface, or a conductive ceramic/metal composite, for example. Conductive layers can define electrodes or other sensing elements or shield layers. Non-conductive layers can define insulating spacers that are positioned between conductive layers. The layers that form the sensor body can be machined as a preformed part and then bonded to an adjacent layer or deposited on an adjacent layer using any suitable deposition technique. If the outer layer of the sensor body is made substantially from a ceramic material then its outer surface can be metallised so that the sensor body can be brazed directly into the housing using conventional brazing techniques without the need for the intermediate bush.

The metal housing parts of the sensor assembly might be manufactured from a low expansion alloy which is specifically designed to have a coefficient of thermal expansion substantially similar to that of the bush and/or the sensor body. If the sensor assembly is exposed to high temperatures during operation then the housing, bush and sensor body all expand at similar rates to minimise the thermal stress between the individual components.

One problem with the use of low expansion alloys is that they tend to oxidise at temperatures approaching 500°C. This places an upper limit on the operating temperature of the sensor assembly. It can be difficult to find a metal that is suitable for use at higher temperatures and which also has a thermal expansion coefficient that is substantially similar to that of the bush and/or the sensor body. A known solution is to use so-called "active braze" techniques which allow certain ceramic materials to be brazed to metals without the need for metallised coatings and also provide a degree of compliance between the two different materials to accommodate the different rates of thermal expansion. In practice, however, the operating temperature of active braze alloys is limited to about 800°C which is still not sufficiently high for certain operations. The compliant coatings that are needed to provide the degree of compliance also tend to oxidise at temperatures below 500°C and it is normally necessary to provide a hermetic seal at the braze interface to minimise the oxidation effect when the operating temperature falls below this threshold.

Further problems are known to exist in situations where large relative movements occur between the component parts of the sensor assembly as a result of thermal expansion. Large relative movement can only be accommodated by increasing the thickness of the compliant coatings and this can place practical limitations on the design of the sensor assembly.

### Summary of the invention

The present invention provides a sensor assembly comprising: a multi-layer sensor body; and a preformed ceramic disc (or "window") bonded to a front part of the sensor body to provide a hermetic seal that excludes gas from any interface between the constituent layers of the sensor body. The front part of the sensor body, in use, will normally be the face of the sensor that is exposed to high operating temperatures, for example.

Providing a hermetic seal between the preformed ceramic disc and the front part of the sensor body means that there is no requirement for the constituent layers to be fully bonded together because gas is excluded from all internal interfaces. This can allow more flexibility in the design and materials used in the sensor body. The sensor assembly can also be exposed to high operating temperatures (e.g. up to about 1500°C) because the constituent layers of the sensor body are not subjected to oxidation.

The sensor body is preferably formed substantially from a ceramic material and can include one or more electrically conductive layers and one or more electrically non-conductive layers, for example. Conductive metal layers may be provided within the sensor body. The precise shape and construction of the sensor body is not a critical feature of the present invention and will depend on the type of sensor assembly.

In the case where the sensor assembly is a sensor for capacitively measuring the distance to a stationary or passing object then it may include an electrode for capacitively coupling with the object. Such a sensor assembly may have a coaxial or triaxial arrangement.

The preformed ceramic disc can be made of a non-porous and/or electrically non-conducting (e.g. insulating) ceramic material. A suitable example would be silicon nitride.

The preformed ceramic disc can be substantially transparent to electromagnetic radiation, i.e. it can form an electromagnetically transparent window. The preformed ceramic disc can have any size or thickness depending on the type of sensor assembly and its expected operating environment. The preformed disc can be produced by machining, for example.

The sensor assembly can be adapted to be mounted or located in a housing that can be formed from a high temperature metal.

### Drawings

Figure 1 is an cross section diagram showing a first sensor assembly according to the preset invention; and
Figure 2 is a cross section diagram showing a second sensor assembly according to the present invention.

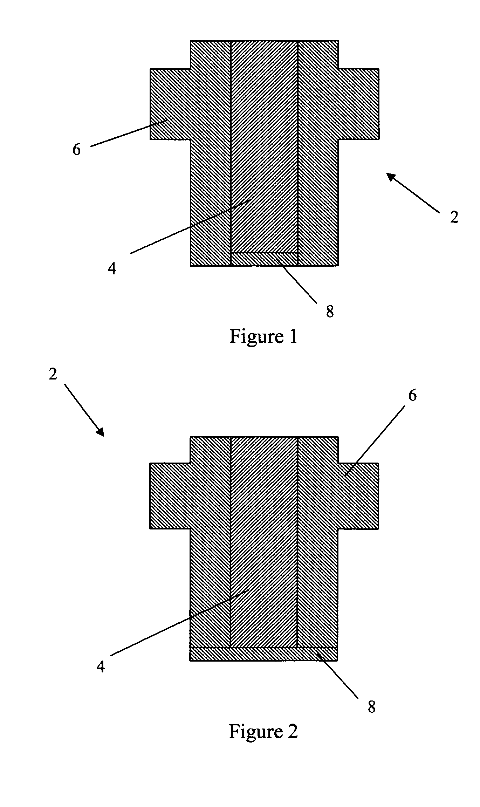

Figures 1 and 2 show a sensor assembly with a sensor body 2 that includes an inner electrode 4 made of electrically conductive ceramic material and an outer layer 6 made of electrically non-conductive ceramic material. The sensor body 2 is adapted to be mounted to a metal housing (not shown).

The outer layer 6 can be deposited on, or bonded to, the inner electrode 4 using any suitable manufacturing technique such that the sensor body 2 is an integral structure. The different ceramic materials that are used to form the electrode 4 and the outer layer 6 can be selected to have substantially similar thermal expansion coefficients. It will be readily appreciated that the sensor body 2 may have any convenient or suitable construction depending on the type of sensor with one or more layers of metal, electrically conductive ceramic, electrically non-conductive ceramic that is made conductive by having a layer of conductive material (e.g. a metal) deposited on its surface, or a conductive ceramic/metal composite, for example.

A preformed disc 8 of non-porous electrically non-conductive ceramic is bonded to a front part of the sensor body 2 by any suitable bonding process, e.g. diffusion bonding or sintering. Once the preformed disc is bonded to the sensor body 2 it provides an electromagnetically transparent window that protects the sensor body from high operating temperatures of up to about 1500°C.

In Figure 1 the preformed disc 8 is located in a recess that is provided in the front part of the sensor body 2 such that the outer edge surface of the disc is bonded to a facing inner surface of the outer layer 6 and a planar surface of the disc is bonded to a facing planar surface of the inner electrode 4. In Figure 2 a planar surface of the preformed disc 8 is bonded to facing planar surfaces of the inner electrode 4 and the outer layer 6. In both arrangements the preformed disc 8 provides a hermetic seal that excludes gas (e.g. air) from the interface between the electrode 4 and the outer layer 6.

## Claims

1. A sensor assembly comprising:
a multi-layer sensor body (2); and
a preformed ceramic disc (8) bonded to a front part of the sensor body (2) to provide a hermetic seal that excludes gas from any interface between the constituent layers (6,8) of the sensor body (2).

2. A sensor assembly according to claim 1, wherein the sensor body (2) is formed substantially from a ceramic material.

3. A sensor assembly according to claim 1 or claim 2, wherein the sensor body (2) includes one or more electrically conductive layers (4) and one or more electrically non-conductive layers (6).

4. A sensor assembly according to any preceding claim, wherein the preformed ceramic disc (8) is made of a non-porous and/or electrically non-conducting ceramic material.

5. A sensor assembly according to any preceding claim, wherein the preformed ceramic disc (8) is substantially transparent to electromagnetic radiation.
